# EUROPÄISCHE PATENTSCHRIFT

(11) **EP 3 700 861 B1**
(45) Veröffentlichungstag und Bekanntmachung des Hinweises auf die Patenterteilung: **17.08.2022**
(21) Anmeldenummer: 18792913.8
(22) Anmeldetag: 19.10.2018
(51) Int. Cl.: C01B 33/107, C23C 16/24, C23C 16/44

(54) **VERFAHREN UND VORRICHTUNG ZUR ENTFERNUNG VON VERUNREINIGUNGEN AUS CHLORSILANEN**
PROCESS AND APPARATUS FOR REMOVAL OF IMPURITIES FROM CHLOROSILANES
PROCÉDÉ ET DISPOSITIF POUR ÉLIMINER DES IMPURETÉS DE CHLOROSILANES

(30) Priorität: 27.10.2017 DE 102017125221
(43) Veröffentlichungstag der Anmeldung: 02.09.2020
(73) Patentinhaber: Nexwafe GmbH, 79108 Freiburg (DE)
(72) Erfinder: SCHILLINGER, Kai, 79106 Freiburg (DE); MILENKOVIC, Nena, 79276 Reute (DE)
(74) Vertreter: LBP Lemcke, Brommer & Partner Patentanwälte mbB
(86) Internationale Anmeldenummer: PCT/EP2018/078782
(87) Internationale Veröffentlichungsnummer: WO 2019/081380

(56) Entgegenhaltungen:
- DD-A1- 240 729
- DE-A1- 10 048 504
- US-A1- 2011 158 857
- Southwest Thermal Technology INC: "Heat Exchanger:Materials & ConstructionShell & Tube", , 31. Dezember 2015 (2015-12-31), XP002788039, Gefunden im Internet: URL:http://www.shell-tube.com/Materials-an d-Construction.html [gefunden am 2019-01-16]

## Beschreibung

Die Herstellung von kristallinen Siliziumschichten für Solarzellen sowie die Mikroelektronik kann unter anderem durch chemische Gasphasenepitaxie von Silizium auf Substraten erfolgen, wodurch im Gegensatz zu konventionellen Herstellungsverfahren durch Sägen von Siliziumblöcken aus dem Czochralski- oder Zonenschmelz-Verfahren deutlich geringere Schichtdicken erreicht werden. Da bei der chemischen Gasphasenepitaxie die Dicke der gebildeten Siliziumschicht durch geeignete Wahl der Reaktionsbedingungen gesteuert werden kann, ist ein nachfolgendes Sägen des Siliziums, wie es bei Siliziumblöcken aus den zuvor genannten Verfahren zwingend notwendig ist, nicht erforderlich, wodurch Sägeverluste vermieden werden können. Die durch die chemische Gasphasenepitaxie ermöglichte Reduzierung der Schichtdicke sowie der Sägeverluste führt somit zu einer deutlichen Verringerung der Produktionskosten.

Als Silizium-Vorläuferverbindung eignen sich u.a. Silane sowie Chlorsilane, wobei die Verwendung von Silanen aufgrund deren Selbstentzündlichkeit in Kontakt mit Luftsauerstoff meist vermieden wird. Aus thermodynamischen Gründen werden bei einer chemischen Gasphasenabscheidung im Allgemeinen nur ein geringer Anteil der eingesetzten Vorläuferverbindung als feste Schicht auf einem Substrat abgeschieden. Dieser Anteil ist abhängig von einer Gaszusammensetzung in der Reaktionskammer der chemischen Gasphasenabscheidung. Bei der Herstellung von kristallinen Siliziumschichten mittels Gasphasenepitaxie unter Verwendung von Chlorsilanen als Vorläuferverbindung, wie beispielsweise Siliziumtetrachlorid oder Trichlorsilan, werden beispielsweise nur rund 25 % des Chlorsilans umgesetzt. Somit fallen dauerhaft umweltbelastende und teils sehr schwierig aufzureinigende Abfallstoffe in Form von gasförmigen Chlorsilan-Gemischen an. Zur Verringerung von Prozesskosten sowie zur Reduzierung dieser umweltbelastenden Abfallstoffe ist es daher insbesondere im großtechnischen Maßstab zwingend erforderlich, das unverbrauchte Chlorsilan aufzureinigen und dem Prozess rückzuführen.

Problematisch bei einem derartigen Recycling des Chlorsilans ist jedoch, dass das aus großtechnischen Anlagen abgeführte Abgas nicht nur unverbrauchte Chlorsilane sowie Wasserstoff als Prozessgas enthält, sondern auch geringe Mengen an unverbrauchten Dotierstoffen sowie Verunreinigungen. Beispielsweise liegen Dotierstoffe in Spuren von wenigen ppb (parts per billion) in den gasförmigen Chlorsilan-Gemischen vor. Derartig niedrige Konzentrationen an Dotierstoffen können durch konventionelles Chlorsilan-Recycling, wie beispielsweise mittels einer destillativen Trennungsapparatur mit vorgeschaltetem Gaswäscher, nicht ausreichend abgetrennt werden. Da jedoch bereits geringe Konzentrationsschwankungen der Dotierstoffe die Halbleitereigenschaften von Silizium stark beeinflussen, muss die Konzentration der Dotierstoffe im Chlorsilan auf wenige ppb genau eingestellt und Verunreinigungen entfernt werden, bevor das Chlorsilan dem eigentlichen Epitaxieprozess erneut zugeführt wird. Derartige hochreine Chlorsilane sind zwar kommerziell erhältlich, jedoch sehr teuer in der Herstellung, was sich letztlich negativ auf die Prozesskosten der chemischen Gasphasenepitaxie auswirkt. Verhältnismäßig günstige Chlorsilane enthalten meist metallhaltige Verunreinigungen, welche die Halbleitereigenschaften von kristallinen Siliziumschichten ebenfalls stark beeinflussen.

Da eine destillative Aufreinigung der Chlorsilan-Gemische für die Entfernung derartiger Verunreinigungen nicht ausreichend ist, wurden beispielsweise Verfahren unter Verwendung von mikroporösen Festphasenmaterialen zur Entfernung der Dotierstoffe vorgeschlagen, welche Festphasenmaterialen die Dotierstoffe aufgrund physikalischer Wechselwirkungen binden und somit aus einem flüssigen oder gasförmigen Chlorsilan-Gemisch entfernen. Die US 4713230 A schlägt beispielsweise ein Verfahren zur Entfernung von Bor-haltigen Dotierstoffen aus Chlorsilanen vor, bei der ein gasförmiges Bor-haltiges Chlorsilan-Gemisch über ein Kieselgel geleitet wird. Dieses Verfahren ermöglicht zwar eine Verringerung der Bor-Konzentration auf bis zu 100 ppba (parts per billion atomic). Bei der Verwendung von Kieselgel fallen jedoch weitere Abfallstoffe an, welche entsprechend entsorgt werden müssen. Des Weiteren hängt die Menge an aufgereinigtem Chlorsilan sowie die Aufreinigungsgeschwindigkeit stark von den Eigenschaften und der Menge des eingesetzten Festphasenmaterials ab, wodurch sich ein derartiges Festphasenmaterial nur sehr schwer in einen Kreisprozess im großtechnischen Maßstab integrieren lässt.

Die DE 100 48 504 A1 offenbart ein Verfahren zur Herstellung von Chlorsilan mit niedrigem Dotierstoffgehalt durch Entfernung von Verunreinigungen aus Chlorsilan, wobei Chlorsilan zur Reinigung in einen Reaktor mit einer beheizten Zone geleitet, welche eine beheizte Fläche mit einer Temperatur im Bereich von 150 °C bis 350 °C aufweist. Die Reinigung des Chlorsilans erfolgt dadurch, dass an der beheizten Fläche die Verunreinigungen, wie beispielsweise Arsin oder Phosphin, thermisch zersetzt werden.

Die US 2011/0158857 A1 offenbart ein Verfahren zur Gasphasenabscheidung von polykristallinem Silizium, bei welchem ungewollte Ablagerungen von polykristallinen Silizium im System dadurch reduziert werden, dass der Reaktor eine spezielle Gasverteilungs-Einrichtung aufweist, welche mehrere Arten von Öffnungen umfasst, die jeweils nur mit einem bestimmten Gas in Verbindung stehen.

Weiter sind auch Wärmetauscher, beispielsweise von Southwest Thermal Technology Inc. bekannt, welche Leitbleche zur Beeinflussung eines Fluidstromes durch die Kammer aufweisen.

Der vorliegenden Erfindung liegt daher die Aufgabe zugrunde, ein Verfahren sowie eine Vorrichtung zur Entfernung von Verunreinigungen, insbesondere von Dotierstoffen, aus Chlorsilanen anzugeben, welche sich zur Aufreinigung sowie zum Recycling von Chlorsilanen im großtechnischen Maßstab eignen.

Diese Aufgabe wird erfindungsgemäß durch ein Verfahren mit den Merkmalen des Anspruchs 1 sowie eine Vorrichtung mit den Merkmalen des Anspruchs 6 gelöst.

Vorteilhafte Weiterbildungen der erfindungsgemäßen Idee sind Gegenstand von Unteransprüchen.

Die Erfindung betrifft ein Verfahren zur Entfernung von Verunreinigungen, insbesondere von Dotierstoffen, aus Chlorsilanen gemäß Anspruch 1. Weiterhin betrifft die Erfindung eine Vorrichtung zur Entfernung von Verunreinigungen, insbesondere von Dotierstoffen, aus Chlorsilanen nach Patentanspruch 6.

Das erfindungsgemäße Verfahren zur Entfernung von Verunreinigungen, insbesondere von Dotierstoffen, aus Chlorsilanen weist folgende Verfahrensschritte auf:
Zunächst erfolgt in einem Verfahrensschritt (a) ein Aufheizen von einer Abscheidefläche auf eine Temperatur von 600 °C bis 1000 °C, bevorzugt auf 700 °C bis 900 °C, besonders bevorzugt auf 750 °C bis 850 °C. In einem Verfahrensschritt (b) wird zumindest ein gasförmiges Chlorsilan-Gemisch mit der aufgeheizten Abscheidefläche in Kontakt gebracht, welches gasförmige Chlorsilan-Gemisch zumindest ein Chlorsilan und zumindest eine Verunreinigung, insbesondere zumindest ein Dotierstoff, umfasst. Daraufhin erfolgt in einem Verfahrensschritt (c) eine zumindest teilweise Abtrennung der Verunreinigung, insbesondere des Dotierstoffes, durch Bildung von polykristallinen Silizium-Abscheidungen auf der Abscheidefläche, welche polykristallinen Silizium-Abscheidungen mit der Verunreinigung, insbesondere mit dem Dotierstoff, angereichert sind. Im darauffolgenden Verfahrensschritt (d) wird das aufgereinigte, gasförmige Chlorsilan-Gemischs abgeführt. Zur Rückführung der polykristallinen Silizium-Abscheidungen und der Verunreinigung, insbesondere des Dotierstoffes, in die Gasphase wird in einem Verfahrensschritt (e) ein Ätzgas mit der Abscheidefläche in Kontakt gebracht, wodurch es zur Bildung eines gasförmigen Ätzgas-Gemischs kommt. In einem weiteren Verfahrensschritt (f) erfolgt ein Abführen des gasförmigen Ätzgas-Gemischs.

Es ist allgemein bekannt, dass es bei der Verwendung von Chlorsilanen in der chemischen Gasphasenepitaxie unter Atmosphärendruck bereits bei Temperaturen ab 600 °C zur Bildung von polykristallinen Silizium-Abscheidungen kommt. Diese polykristallinen Silizium-Abscheidungen sind bei der chemischen Gasphasenepitaxie unerwünschte Nebenprodukte, welche u.a. zur Verstopfung von Gasleitungen der Epitaxiekammer führen können, weswegen die Epitaxiekammer sowie die dazugehörigen Gasleitungen regelmäßig von diesen polykristallinen Silizium-Abscheidungen befreit werden müssen.

Untersuchungen des Anmelders haben ergeben, dass sich Verunreinigungen und Dotierstoffe, welche in den Chlorsilanen enthalten sind, in den polykristallinen Silizium-Abscheidungen anreichern und dadurch aus den Chlorsilan-Gemischen entfernt werden können. Grund hierfür ist, dass polykristalline Silizium-Abscheidungen eine Vielzahl an Kristallfehler aufweisen, in welchen sich die Verunreinigungen und Dotierstoffe einlagern bzw. anreichern. Darüber hinaus sind die Zerfallstemperaturen von gängigen Dotierstoffverbindungen, insbesondere Hydride, insbesondere Phosphin und Diboran, geringer als jene von Chlorsilanen. Hierdurch können bereits durch eine sehr geringe Menge gebildeten polykristallinen Siliziums große Anteile der Verunreinigungen und Dotierstoffe abgefangen werden. Die gebildeten polykristallinen Silizium-Abscheidungen lassen sich gemeinsam mit den Verunreinigungen und/oder den Dotierstoffen mittels eines Ätzgases erneut in die Gasphase überführen und ableiten. Somit ermöglicht das erfindungsgemäße Verfahren eine Entfernung von Verunreinigungen aus Chlorsilan-Gemischen ohne den Einsatz weiterer Aufreinigungsmaterialien. Das Aufheizen der Abscheidefläche auf eine bestimmte Temperatur ermöglicht die Abscheiderate an polykristallinem Silizium auf der Abscheidefläche und somit eine Abtrennung der Verunreinigungen gezielt einzustellen.

In einer vorteilhaften Ausgestaltung des Verfahrens erfolgt in Schritt (b) das In-Kontakt-Bringen des gasförmigen Chlorsilan-Gemischs und der Abscheidefläche in Anwesenheit eines Prozessgases. Es liegt dabei im Rahmen der Erfindung, dass eine Gesamtmenge des gasförmigen Chlorsilan-Gemischs in einem Stoffmengenverhältnis von 1 bis 10 mol% in dem Prozessgas vorliegt. Die Erfindung ist jedoch nicht hierauf beschränkt.

Da die Abscheiderate von polykristallinem Silizium temperaturabhängig ist und in Anwesenheit von Wasserstoff erhöht werden kann, wird in einer weiteren vorteilhaften Ausgestaltung des erfindungsgemäßen Verfahrens Wasserstoff als Prozessgas eingesetzt.

In einer vorteilhaften Ausgestaltung des Verfahrens weist das in Schritt (d) abgeführte aufgereinigte, gasförmige Chlorsilan-Gemisch eine Restkonzentration der Verunreinigung, insbesondere des Dotierstoffes, kleiner 1000 ppb, bevorzugt kleiner 100 ppb, besonders bevorzugt kleiner 15 ppb auf. Chlorsilane mit einer derartig niedrigen Konzentration an Verunreinigungen und/oder Dotierstoffen eignen sich zur Rückführung in einen entsprechenden Epitaxieprozess.

In einer weiteren vorteilhaften Ausgestaltung handelt es sich bei dem Chlorsilan um Tetrachlorsilan und/oder Trichlorsilan und/oder Dichlorsilan. Es liegt jedoch auch im Rahmen der Erfindung, dass höhermolekulare Chlorsilane verwendet werden können.

Eine weitere vorteilhafte Ausgestaltung des Verfahrens sieht vor, dass die Bildung von polykristallinen Silizium-Abscheidungen an der Abscheidefläche bei einem Druck von 0,8 × 10⁵ Pa bis 1,2 × 10⁵ Pa stattfindet. Es liegt dabei im Rahmen der Erfindung, dass das erfindungsgemäße Verfahren bei im Wesentlichen Atmosphärendruck durchgeführt wird. Hierdurch wird eine zeitintensive Überführung der Abscheidefläche ins Vakuum vermieden, wodurch die Dauer der Aufreinigung des Chlorsilan-Gemischs deutlich verringert wird.

In einer weiteren vorteilhaften Ausgestaltung des erfindungsgemäßen Verfahrens handelt es sich bei dem Ätzgas um Chlorwasserstoff. Durch ein In-Kontakt-Bringen der Abscheidefläche mit Chlorwasserstoff werden die darauf gebildeten polykristallinen Silizium-Abscheidungen in die Gasphase überführt unter Bildung eines Ätzgasgemisches.

Ein weiterer Aspekt der vorliegenden Erfindung ist eine Vorrichtung zur Entfernung von Verunreinigungen aus Chlorsilanen, insbesondere zur Durchführung eines Verfahrens nach einem der Ansprüche 1 bis 5, aufweisend:
Eine Abscheidekammer, welche Abscheidekammer zumindest eine Abscheidefläche zum Abscheiden von polykristallinem Silizium aufweist, wobei die Abscheidekammer eine Heizvorrichtung aufweist, welche zum Aufheizen der Abscheidefläche dient und die Heizvorrichtung ausgebildet ist die Abscheidefläche auf 600 °C bis 1000 °C, bevorzugt auf 700 °C bis 900 °C, besonders bevorzugt auf 750 °C bis 850 °C aufzuheizen, zumindest ein Gaseinlass und zumindest ein Gasauslass, zumindest eine Fluidzufuhrleitung, vorzugsweise Gaszufuhrleitung, welche Fluidzufuhrleitung mit dem Gaseinlass der Abscheidekammer verbunden ist und zumindest eine Fluidabfuhrleitung, vorzugsweise Gasabfuhrleitung, welche Fluidabfuhrleitung mit dem Gasauslass der Abscheidekammer verbunden ist.

In einer ersten vorteilhaften Ausgestaltung der Erfindung weist die Abscheidekammer eine Heizvorrichtung auf, welche Heizvorrichtung zum der Fluidzufuhrleitung und/oder der Fluidabfuhrleitung dient. Diese Heizvorrichtung kann beispielsweise als elektrisch betriebene Spulen ausgebildet sein, welche die Abscheidekammer und/oder der Fluidzufuhrleitung und/oder der Fluidabfuhrleitung zumindest teilweise umschließen. Die Erfindung ist jedoch nicht hierauf beschränkt.

Es liegt hierbei im Rahmen der Erfindung, dass durch diese Heizvorrichtung mehrere Heizzonen ausgebildet werden können, um die Bildung von polykristallinen Abscheidungen zu optimieren. Vorteilhafterweise wird dadurch erreicht, dass nur ein geringer Anteil des Chlorsilans als polykristallines Silizium an der-Abscheidefläche abgeschieden wird, sodass der Hauptteil des Chlorsilans im aufgereinigten, gasförmigen Chlorsilangemisch abgeführt werden kann. Gleichzeitig können jedoch in der geringen Menge an abgeschiedenem polykristallinen Silizium ein Großteil der Verunreinigungen angereichert werden. Somit kommt es in vorteilhafter Weise zu einer Aufreinigung des gasförmigen Chlorsilangemischs bei gleichzeitig geringem Verbrauch der Silizium-Vorläuferverbindung. Beispielsweise kann eine erste Heizzone im Bereich der Gaszufuhrleitungen und/oder der Gaseinlässe ausgebildet sein, um das gasförmige Chlorsilan-Gemisch aufzuheizen, bevor es mit der Abscheidefläche in Kontakt gebracht wird. Weiterhin wirkt sich die Ausbildung mehrerer Heizzonen positiv auf das Strömungsverhalten des gasförmigen Chlorsilan-Gemischs und/oder des Prozessgases in der Abscheidekammer aus.

In einer zweiten vorteilhaften Ausgestaltung der erfindungsgemäßen Vorrichtung ist die Abscheidekammer als Hohlkörper mit Außenwandung ausgebildet, welche Außenwandung einen Innenbereich der Abscheidekammer umschließt, in welchem Innenbereich zumindest eine Trennwand zum Führen eines Gasflusses angeordnet ist.

In einer weiteren vorteilhaften Ausgestaltung der erfindungsgemäßen Vorrichtung ist die Abscheidefläche zumindest teilweise auf der dem Innenbereich zugewandten Seite der Außenwandung der Abscheidekammer und/oder zumindest teilweise auf der Trennwand angeordnet ist. Daher dient die Trennwand nicht nur zur Führung des Gasflusses, sondern auch zur Vergrößerung der Abscheidefläche, indem polykristallines Silizium nicht nur auf der dem Innenbereich zugewandten Seite der Außenwandung gebildet werden kann, sondern auch auf der Oberfläche der Trennwand. Somit wird die Menge an abgeschiedenen polykristallinem Silizium auf der Abscheidefläche erhöht.

Um die Menge an polykristallinen Silizium-Abscheidungen weiter zu erhöhen und die Wegstrecke, welche der Glasfluss durch die Abscheidekammer zurücklegt, zu verlängern, weist der Innenbereich der Abscheidekammer in einer weiteren vorteilhaften Ausgestaltung der erfindungsgemäßen Vorrichtung eine Mehrzahl an Trennwänden auf, welche Trennwände den Innenbereich derart unterteilen, dass ein in die Abscheidekammer eingeleitetes Gas mäandernd durch die Abscheidekammer geführt wird, wobei vorzugsweise die Trennwände im Wesentlichen senkrecht zur Längsachse der Abscheidekammer angeordnet sind.

In einer weiteren bevorzugten Ausgestaltung der erfindungsgemäßen Vorrichtung sind der Gaseinlass und der Gasauslass auf zwei sich im Wesentlichen gegenüberliegenden Seiten der Außenwandung der Abscheidekammer angeordnet. Hierdurch wird erreicht, dass der Gasfluss die maximal mögliche Wegstrecke durch die Abscheidekammer zurücklegt, wodurch die Menge an polykristallinen Silizium-Abscheidungen weiter erhöht wird.

Um die Abscheidefläche weiter zu vergrößern und somit die Aufnahmemenge der Verunreinigung, insbesondere des Dotierstoffs zu steigern, ist die Abscheidefläche in einer weiteren vorteilhaften Ausgestaltung der erfindungsgemäßen Vorrichtung zumindest teilweise strukturiert ist.

In einer weiteren bevorzugten Ausgestaltung der erfindungsgemäßen Vorrichtung weist die Abscheidefläche Lamellen und/oder Kanäle auf, um die Oberfläche zu vergrößern.

Die Abscheidefläche ist in einer weiteren vorteilhaften Ausgestaltung der erfindungsgemäßen Vorrichtung aus Graphit oder Siliziumcarbid ausgebildet.

Weitere vorteilhafte Eigenschaften der Erfindung ergeben sich aus der nachfolgenden Beschreibung von Ausführungsbeispielen anhand der Zeichnung. Dabei zeigt:
- Figur 1: eine schematische Darstellung eines ersten Ausführungsbeispiels einer erfindungsgemäßen Vorrichtung zur Entfernung von Verunreinigungen aus Chlorsilanen und
- Figur 2: eine schematische Darstellung eines zweiten Ausführungsbeispiels einer erfindungsgemäßen Vorrichtung zur Entfernung von Verunreinigungen aus Chlorsilanen.

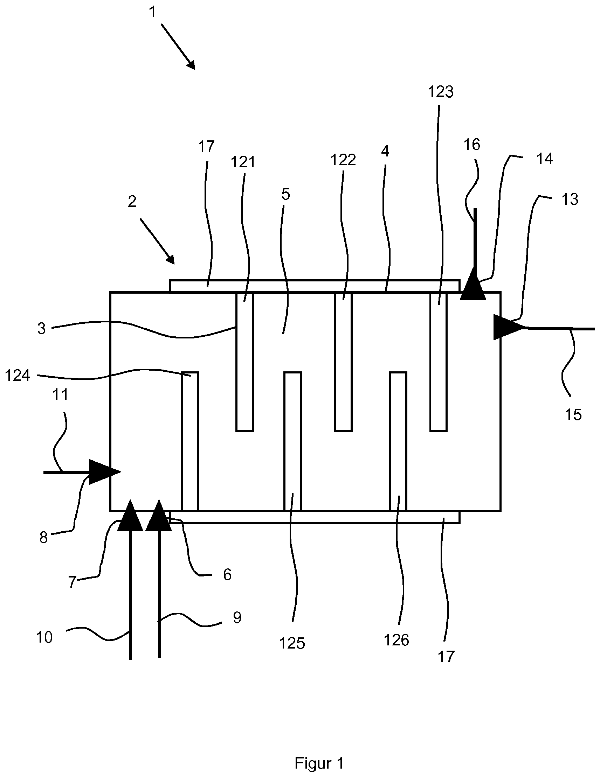

Figur 1 zeigt ein erstes Ausführungsbeispiel einer erfindungsgemäßen Vorrichtung 1 zur Entfernung von Verunreinigungen aus Chlorsilanen. Diese Vorrichtung 1 weist eine Abscheidekammer 2 und eine Abscheidefläche 3 auf. Im vorliegenden Ausführungsbeispiel ist die Abscheidefläche 2 aus Graphit ausgebildet.

Die Abscheidekammer 2 ist als Hohlkörper mit Außenwandung 4 ausgebildet, welche Außenwandung 4 einen Innenbereich 5 der Abscheidekammer 2 umschließt. Weiterhin weist die Abscheidekammer 2 drei Gaseinlässe 6, 7, 8 auf, welche mit Gaszufuhrleitungen 9, 10, 11 verbunden sind. Über die Gaseinlässe 6, 7, 8 können ein gasförmiges Chlorsilan-Gemisch, ein Prozessgas sowie ein Ätzgas zeitlich und/oder räumlich getrennt voneinander in die Abscheidekammer 2 eingeleitet werden. Im vorliegenden Ausführungsbeispiel weist die Abscheidekammer 2 sowie die Abscheidefläche 3 eine Temperatur von 700 °C auf. Liegt das Chlorsilan-Gemisch bei Raumtemperatur als Flüssigkeit vor, so kann an der Gaszufuhrleitung 9 ein optionaler Verdampfer (nicht dargestellt) angeordnet sein.

Des Weiteren sind im Innenbereich 5 der Abscheidekammer 2 sechs Trennwände 121, 122, 123, 124, 125, 126 zum Führen eines Gasflusses angeordnet. Diese Trennwände 121, 122, 123, 124, 125, 126 unterteilen den Innenbereich 5 der Abscheidekammer 2 derart, dass ein in die Abscheidekammer 2 eingeleitetes Gas mäandernd durch die Abscheidekammer 2 geführt wird. Wie aus Figur 1 hervorgeht, sind die Trennwände 121, 122, 123, 124, 125, 126 im vorliegenden Ausführungsbeispiel senkrecht zur Längsachse der Abscheidekammer 2 angeordnet. Die Erfindung ist jedoch auf eine derartige Anordnung der Trennwände 121, 122, 123, 124, 125, 126 nicht beschränkt.

Zum Abführen des aufgereinigten, gasförmigen Chlorsilan-Gemischs sowie des gasförmigen Ätzgas-Gemischs sind an der Außenwandung 4 der Abscheidekammer 2 zwei Gasauslässe 13, 14 angeordnet, welche Gasauslässe 13, 14 jeweils mit einer Gasausfuhrleitung 15, 16 verbunden sind. Die Gasauslässe 13, 14 sind dabei derart an der Abscheidekammer 2 angeordnet, dass sie den drei Gaseinlässen 6, 7, 8 gegenüberliegen. Hierdurch wird erreicht, dass der Gasfluss durch die Abscheidekammer eine maximal mögliche Wegstrecke zurücklegt, wodurch die Abreicherung an Verunreinigungen und/oder Dotierstoffen maximiert wird.

Das Ablauf eines Ausführungsbeispiels des erfindungsgemäßen Verfahren lässt sich anhand der Figur 1 folgendermaßen beschreiben: Zur Entfernung von Verunreinigungen und/oder Dotierstoffen aus Chlorsilanen wird die Abscheidefläche 3 der Abscheidekammer 2 im vorliegenden Ausführungsbeispiel auf eine Temperatur von 700 °C unter Atmosphärendruck aufgeheizt. In Abhängigkeit von der Zusammensetzung des gasförmigen Chlorsilan-Gemischs kann die Abscheidefläche 3 jedoch auch einen auf eine andere Temperatur im Bereich von 600 °C bis 1000 °C aufgeheizt werden.

Daraufhin wird ein gasförmiges Chlorsilan-Gemisch, welches im vorliegenden Ausführungsbeispiel einen phosphorhaltigen Dotierstoff sowie Trichlorsilan enthält, über die Gaszufuhrleitung 9 mittels des Gaseinlasses 6 in den Innenbereich 5 der Abscheidekammer 2 eingeleitet. Zeitgleich wird über den Gaseinlass 8, welcher mit der Gaszufuhrleitung 11 verbunden ist, ein Prozessgas in die Abscheidekammer 2 eingeleitet. Es liegt jedoch auch im Rahmen der Erfindung, dass das gasförmige Chlorsilan-Gemisch und das Prozessgas nacheinander in die Reaktionskammer eingeleitet werden.

Im vorliegenden Ausführungsbeispiel werden das Chlorsilan-Gemisch und das Prozessgas solcher Art in den Innenbereich 5 der Abscheidekammer 2 eingeleitet, dass das Chlorsilan-Gemisch in einem Stoffmengenverhältnis von 3 mol% in dem Prozessgas vorliegt. Als Prozessgas wird der Abscheidekammer 2 hochreiner Wasserstoff zugeführt.

Aufgrund der Temperatur von 700 °C kommt es an der Abscheidefläche 3 der Abscheidekammer 2 zur Bildung von polykristallinen Silizium-Abscheidungen, welche polykristallinen Silizium-Abscheidungen mit dem Phosphor-haltigen Dotierstoff angereichert sind. Hierbei wird die Menge an verbrauchtem Chlorsilan durch die gewählte Temperatur und Gaszusammensetzung eingestellt. Das hierbei verbrauchte Chlorsilan steht nicht mehr als Produktivgas zur Verfügung. In dem das Dotierstoff-haltige Chlorsilan-Gemisch die Abscheidekammer 2 vollständig durchfließt, wird es von dem Dotierstoff annähernd vollständig befreit. Die Größe der aktiven Oberfläche beeinflusst die Reinigungseffizienz der erfindungsgemäßen Vorrichtung. Das aufgereinigte, gasförmige Chlorsilan-Gemisch wird daraufhin mittels des Gasauslasses 13 über die Gasausfuhrleitung 15 aus der Abscheidekammer 2 abgeführt. Im vorliegenden Ausführungsbeispiel weist das abgeführte aufgereinigte, gasförmige Chlorsilan-Gemisch eine Restkonzentration des Dotierstoffes von 15 ppb auf. Nachdem das aufgereinigte, gasförmige Chlorsilan-Gemisch aus der Abscheidekammer 2 abgeführt wurde, wird der Abscheidekammer über den Gaseinlass 7, welcher mit der Gaszufuhrleitung 10 verbunden ist, ein Ätzgas zugeführt. Im vorliegenden Ausführungsbeispiel wird als Ätzgas Chlorwasserstoff verwendet. Der der Abscheidekammer 2 zugeführte Chlorwasserstoff dient zur Rückführung der polykristallinen Silizium-Abscheidungen und des Dotierstoffes in die Gasphase, wodurch ein gasförmiges Ätzgas-Gemisch ausgebildet wird. Dieses gasförmige Ätzgas-Gemisch wird über den Gasauslass 14, welcher mit der Gasabfuhrleitung 16 verbunden ist, aus der Abscheidekammer 2 abgeführt. Durch das beschriebene Verfahren kann somit abwechselnd ein mit Dotierstoff verunreinigtes Chlorsilan-Gemisch aufgereinigt und die dabei entstandenen polykristallinen Silizium-Abscheidungen aus der Abscheidekammer 2 entfernt werden.

Wie aus Figur 1 weiterhin hervorgeht, weist die Abscheidekammer 2 eine Heizvorrichtung 17 auf. Diese dient dazu, die Abscheidefläche 3 auf eine Temperatur im Bereich von 600 °C bis 1000 °C aufzuheizen, wodurch die Abscheidung von polykristallinem Silizium ermöglicht wird. Diese Heizvorrichtung 17 ist vorliegend als elektrisch betriebene Spulen ausgebildet sein. Im vorliegenden Ausführungsbeispiel ist die Abscheidekammer 2 annähernd vollständig von elektrisch betriebenen Spulen (35 Watt) umgeben, welche die Abscheidefläche 3 auf 700 °C aufgeheizt. Die Erfindung ist jedoch nicht hierauf beschränkt. Es können auch andere Arten von Heizvorrichtungen zum Einsatz kommen.

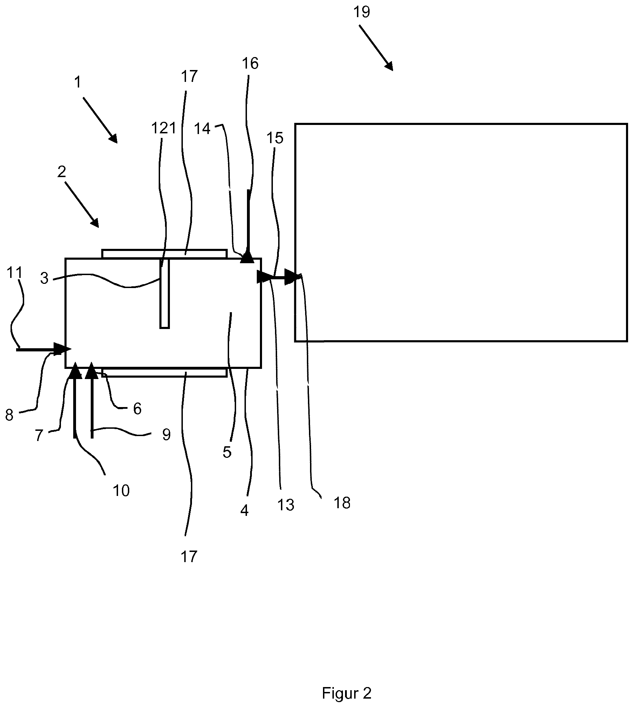

Figur 2 zeigt ein zweites Ausführungsbeispiel einer erfindungsgemäßen Vorrichtung 1 zur Entfernung von Verunreinigungen aus Chlorsilanen. Die Vorrichtung 1 weist einen weitgehend zu der in Figur 1 beschriebenen Ausgestaltung identischen Aufbau auf, weshalb auf weitere Einzelheiten zunächst nicht einzugehen ist. Die in Figur 2 gezeigte Abscheidekammer 2 weist nur eine Trennwand 121 auf; sie kann jedoch, je nach Anforderung, um weitere Trennwände erweitert werden.

Wie in Figur 2 gezeigt ist, kann die Abscheidekammer 2 über die Gasausfuhrleitung 15 mit einem Gaseinlass 18 einer der Abscheidekammer 2 nachfolgenden Vorrichtung 19 zur chemischen Gasphasenepitaxie verbunden werden. Ein derartiger Aufbau ermöglicht, dass das in der Abscheidekammer 2 aufgereinigte, gasförmige Chlorsilan-Gemisch einer nachfolgenden Vorrichtung 19 zur chemischen Gasphasenepitaxie zugeführt und zur Bildung von kristallinen Siliziumschichten verwendet werden kann. Die Erfindung ist jedoch nicht auf eine derartige Anwendung beschränkt.

## Patentansprüche

1. Verfahren zur Entfernung von Verunreinigungen, insbesondere von Dotierstoffen, aus Chlorsilanen, welches die folgenden Schritte aufweist:
(a) Aufheizen von einer Abscheidefläche (3) auf eine Temperatur von 600 °C bis 1000 °C, bevorzugt auf 700 °C bis 900 °C, besonders bevorzugt auf 750 °C bis 850 °C;
(b) In-Kontakt-Bringen von zumindest einem gasförmigen Chlorsilan-Gemisch mit der aufgeheizten Abscheidefläche (3), welches gasförmige Chlorsilan-Gemisch zumindest ein Chlorsilan und zumindest eine Verunreinigung, insbesondere zumindest ein Dotierstoff, umfasst;
(c) zumindest teilweise Abtrennung der Verunreinigung, insbesondere des Dotierstoffes, durch Bildung von polykristallinen Silizium-Abscheidungen, auf der Abscheidefläche (3), welche polykristallinen Silizium-Abscheidungen mit der Verunreinigung, insbesondere mit dem Dotierstoff, angereichert sind;
(d) Abführen des aufgereinigten, gasförmigen Chlorsilan-Gemischs;
(e) In-Kontakt-Bringen eines Ätzgases mit der aufgeheizten Abscheidefläche (3) zur Rückführung der polykristallinen Silizium-Abscheidungen und der Verunreinigung, insbesondere des Dotierstoffes, in die Gasphase unter Bildung eines gasförmigen Ätzgas-Gemischs; und
(f) Abführen des gasförmigen Ätzgas-Gemischs.

2. Verfahren nach Anspruch 1,
**dadurch gekennzeichnet,**
**dass** in Schritt (b) das In-Kontakt-Bringen des gasförmigen Chlorsilan-Gemischs und der Abscheidefläche (3) in Anwesenheit eines Prozessgases erfolgt.

3. Verfahren nach Anspruch 1 oder 2,
**dadurch gekennzeichnet,**
**dass** es sich bei dem Prozessgas um Wasserstoff handelt und/oder dass es sich bei dem Ätzgas um Chlorwasserstoff handelt.

4. Verfahren nach einem der Ansprüche 1 bis 3,
**dadurch gekennzeichnet,**
**dass** es sich bei dem Chlorsilan um Siliziumtetrachlorid und/oder Trichlorsilan und/oder Dichlorsilan handelt.

5. Verfahren nach einem der Ansprüche 1 bis 4,
**dadurch gekennzeichnet,**
**dass** die Bildung von polykristallinen Silizium-Abscheidungen an der Abscheidefläche (3) bei einem Druck von 0,8 × 10⁵ Pa bis 1,2 × 10⁵ Pa, vorzugsweise bei Atmosphärendruck abläuft.

6. Vorrichtung (1) zur Entfernung von Verunreinigungen aus Chlorsilanen, insbesondere zur Durchführung eines Verfahrens nach einem der Ansprüche 1 bis 5, aufweisend:
- eine Abscheidekammer (2), welche Abscheidekammer (2) zumindest eine Abscheidefläche (3) zum Abscheiden von polykristallinen Silizium aufweist, wobei die Abscheidekammer (2) eine Heizvorrichtung (17) aufweist, welche zum Aufheizen der Abscheidefläche (3) dient und die Heizvorrichtung (17) ausgebildet ist, die Abscheidefläche (3) auf 600 °C bis 1000 °C, bevorzugt auf 700 °C bis 900 °C, besonders bevorzugt auf 750 °C bis 850 °C aufzuheizen;
- zumindest ein Gaseinlass (6, 7, 8) und zumindest ein Gasauslass (13, 14);
- zumindest eine Fluidzufuhrleitung (9, 10, 11), vorzugsweise Gaszufuhrleitung, welche Fluidzufuhrleitung (9, 10, 11) mit dem Gaseinlass (6, 7, 8) der Abscheidekammer (2) verbunden ist; und
- zumindest eine Fluidabfuhrleitung (15, 16), vorzugsweise Gasabfuhrleitung, welche Fluidabfuhrleitung (15, 16) mit dem Gasauslass (13, 14) der Abscheidekammer verbunden ist.

7. Vorrichtung nach Anspruch 6,
**dadurch gekennzeichnet,**
**dass** die Abscheidekammer (2) eine Heizvorrichtung (17) aufweist, welche Heizvorrichtung (17) zum Aufheizen der Fluidzufuhrleitung (9, 10, 11) und/oder der Fluidabfuhrleitung (15, 16) dient.

8. Vorrichtung nach einem der Ansprüche 6 oder 7,
**dadurch gekennzeichnet,**
**dass** die Abscheidekammer (2) als Hohlkörper mit Außenwandung (4) ausgebildet ist, welche Außenwandung (4) einen Innenbereich (5) der Abscheidekammer (2) umschließt, in welchem Innenbereich (5) zumindest eine Trennwand (121, 122, 123, 124, 125, 126) zum Führen eines Gasflusses angeordnet ist.

9. Vorrichtung nach Anspruch 8,
**dadurch gekennzeichnet,**
**dass** die Abscheidefläche (3) zumindest teilweise auf der dem Innenbereich (6) zugewandten Seite der Außenwandung (4) der Abscheidekammer (2) und/oder zumindest teilweise auf der Trennwand (121, 122, 123, 124, 125, 126) angeordnet ist.

10. Vorrichtung nach Anspruch 8 oder 9,
**dadurch gekennzeichnet,**
**dass** der Innenbereich (5) der Abscheidekammer (2) eine Mehrzahl an Trennwänden (121, 122, 123, 124, 125, 126) aufweist, welche Trennwände (121, 122, 123, 124, 125, 126) den Innenbereich (5) derart unterteilen, dass ein in die Abscheidekammer (2) eingeleitetes Gas mäandernd durch die Abscheidekammer (2) geführt wird, wobei vorzugsweise die Trennwände (121, 122, 123, 124, 125, 126) im Wesentlichen senkrecht zur Längsachse der Abscheidekammer (2) angeordnet sind.

11. Vorrichtung nach einem der Ansprüche 6 bis 10,
**dadurch gekennzeichnet,**
**dass** der Gaseinlass (6, 7, 8) und der Gasauslass (13, 14) auf zwei sich im Wesentlichen gegenüberliegenden Seiten der Außenwandung (4) der Abscheidekammer (2) angeordnet sind.

12. Vorrichtung nach einem der Ansprüche 6 bis 11,
**dadurch gekennzeichnet,**
**dass** die Abscheidefläche (3) zumindest teilweise strukturiert ist.

13. Vorrichtung nach einem der Ansprüche 6 bis 12,
**dadurch gekennzeichnet,**
**dass** die Abscheidefläche (3) Lamellen und/oder Kanäle aufweist.

14. Vorrichtung nach einem der Ansprüche 6 bis 13,
**dadurch gekennzeichnet,**
**dass** die Abscheidefläche (3) aus Graphit oder Siliziumcarbid ausgebildet ist.

## Claims

1. A method of removing contaminants, particularly doping agents, from chlorosilanes, which includes the following steps:
(a) heating a deposition surface (3) to a temperature of 600°C to 1000°C, preferably to 700°C to 900°C, particularly preferably to 750°C to 850°C;
(b) bringing at least one gaseous chlorosilane mixture into contact with the heated deposition surface (3), which gaseous chlorosilane mixture includes at least one chlorosilane and at least one contaminant, particularly at least one doping agent;
(c) at least partially removing the contaminant, particularly the doping agent, by forming polycrystalline silicon deposits on the deposition surface (3), which polycrystalline silicon deposits are enriched with the contaminant, particularly with the doping agent;
(d) discharging the purified gaseous chlorosilane mixture;
(e) bringing an etching gas into contact with the heated deposition surface (3) to return the polycrystalline silicon deposits and the contaminant, particularly the doping agent, into the gas phase whilst forming a gaseous etching gas mixture; and
(f) discharging the gaseous etching gas mixture.

2. A method as claimed in Claim 1, **characterised in that** in step (b), the bringing into contact of the gaseous chlorosilane mixture and the deposition surface (3) occurs in the presence of a process gas.

3. A method as claimed in Claim 1 or 2, **characterised in that** the process gas is hydrogen and/or that the etching gas is hydrogen chloride.

4. A method as claimed in one of Claims 1 to 3, **characterised in that** the chlorosilane is silicon tetrachloride and/or trichlorosilane and/or dichlorosilane.

5. A method as claimed in one of Claims 1 to 4, **characterised in that** the formation of polycrystalline silicon deposits on the deposition surface (3) occurs at a pressure of 0.8 × 10⁵ Pa to 1.2 × 10⁵ Pa, preferably at atmospheric pressure.

6. Apparatus (1) for removing contaminants from chlorosilanes, particularly for carrying out a method as claimed in one of Claims 1 to 5, including:
- a deposition chamber (2), which deposition chamber (2) includes at least one deposition surface (3) for the deposition of polycrystalline silicon, wherein the deposition chamber (2) includes a heating device (17), which serves to heat the deposition surface (3) and the heating device (17) is constructed to heat the deposition surface (3) to 600°C to 1000°C, preferably to 700°C to 900°C, particularly preferably to 750°C to 850°C;
- at least one gas inlet (6, 7, 8) and at least one gas outlet (13, 14);
- at least one fluid supply conduit (9, 10, 11), preferably a gas supply conduit, which fluid supply conduit (9, 10, 11) is connected to the gas inlet (6, 7, 8) of the deposition chamber (2); and
- at least one fluid discharge conduit (15, 16), preferably a gas discharge conduit, which fluid discharge conduit (15, 16) is connected to the gas outlet (13, 14) of the deposition chamber.

7. Apparatus as claimed in Claim 6, **characterised in that** the deposition chamber (2) includes a heating device (17), which heating device (17) serves to heat the fluid supply conduit (9, 10, 11) and/or the fluid discharge conduit (15, 16).

8. Apparatus as claimed in one of Claims 6 or 7, **characterised in that** the deposition chamber (2) is constructed as a hollow body with an outer wall (4), which outer wall (4) surrounds an inner region (5) of the deposition chamber (2), in which inner region (5) is arranged at least one partition wall (121, 122, 123, 124, 125, 126) for guiding a gas flow.

9. Apparatus as claimed in Claim 8, **characterised in that** the deposition surface (3) is arranged at least partially on the side of the outer wall (4) of the deposition chamber (2) directed towards the inner region (6) and/or at least partially on the partition wall (121, 122, 123, 124, 125, 126).

10. Apparatus as claimed in Claim 8 or 9, **characterised in that** the inner region (5) of the deposition chamber (2) includes a plurality of partition walls (121, 122, 123, 124, 125, 126), which partition walls (121, 122, 123, 124, 125, 126) divide up the inner region (5) such that a gas introduced into the deposition chamber (2) is conducted in a serpentine course through the deposition chamber (2), wherein the partition walls (121, 122, 123, 124, 125, 126) are preferably arranged substantially perpendicular to the longitudinal axis of the deposition chamber (2).

11. Apparatus as claimed in one of Claims 6 to 10, **characterised in that** the gas inlet (6, 7, 8) and the gas outlet (13, 14) are arranged on two substantially opposite sides of the outer wall (4) of the deposition chamber (2).

12. Apparatus as claimed in one of Claims 6 to 11, **characterised in that** the deposition surface (3) is at least partially structured.

13. Apparatus as claimed in one of Claims 6 to 12, **characterised in that** the deposition surface (3) affords ribs and/or channels.

14. Apparatus as claimed in one of Claims 6 to 13, **characterised in that** the deposition surface (3) is formed of graphite or silicon carbide.

## Revendications

1. Procédé pour éliminer des impuretés, en particulier des substances de dopage, de chlorosilanes, qui comporte les étapes suivantes :
(a) chauffer une surface de dépôt (3) à une température de 600°C à 1000°C, de manière préférée à 700°C à 900°C, de manière particulièrement préférée à 750°C à 850°C ;
(b) mettre en contact au moins un mélange gazeux de chlorosilanes avec la surface de dépôt (3) chauffée, lequel mélange gazeux de chlorosilanes comprend au moins un chlorosilane et au moins une impureté, en particulier au moins une substance de dopage ;
(c) séparer au moins partiellement l'impureté, en particulier de la substance de dopage, par formation de dépôts de silicium polycristallins, sur la surface de dépôt (3), lesquels dépôts de silicium polycristallins sont enrichis avec l'impureté, en particulier avec la substance de dopage ;
(d) évacuer le mélange gazeux de chlorosilanes purifié ;
(e) mettre en contact un gaz d'attaque avec la surface de séparation (3) chauffée pour ramener les dépôts de silicium polycristallins et l'impureté, en particulier la substance de dopage, à la phase gazeuse avec formation d'un mélange gazeux de gaz d'attaque ; et
(f) évacuer le mélange gazeux de gaz d'attaque.

2. Procédé selon la revendication 1,
**caractérisé**
**en ce qu'**à l'étape (b), la mise en contact du mélange gazeux de chlorosilanes et de la surface de dépôt (3) se fait en présence d'un gaz de traitement.

3. Procédé selon la revendication 1 ou 2,
**caractérisé**
**en ce que** pour le gaz de traitement, il s'agit d'hydrogène et/ou **en ce que** pour le gaz d'attaque, il s'agit de chlorure d'hydrogène.

4. Procédé selon l'une des revendications 1 à 3,
**caractérisé**
**en ce que** pour le chlorosilane, il s'agit de tétrachlorure de silicium et/ou de trichlorosilane et/ou de dichlorosilane.

5. Procédé selon l'une des revendications 1 à 4,
**caractérisé**
**en ce que** la formation de dépôts de silicium polycristallins sur la surface de dépôt (3) se fait à une pression de 0,8 × 10⁵ Pa à 1,2 × 10⁵ Pa, de manière préférée à la pression atmosphérique.

6. Dispositif pour éliminer des impuretés de chlorosilanes, en particulier pour la réalisation d'un procédé selon l'une des revendications 1 à 5, comportant :
- une chambre de dépôt (2), laquelle chambre de dépôt (2) comporte au moins une surface de dépôt (3) pour le dépôt de silicium polycristallin, dans lequel la chambre de dépôt (2) comporte un dispositif de chauffage (17) qui sert au chauffage de la surface de dépôt (3) et le dispositif de chauffage (17) est agencé pour chauffer la surface de dépôt (3) à 600°C à 1000°C, de manière préférée à 700°C à 900°C, de manière particulièrement préférée à 750°C à 850°C ;
- au moins une entrée de gaz (6, 7, 8) et au moins une sortie de gaz (13, 14) ;
- au moins une conduite d'amenée de fluide (9, 10, 11), de manière préférée une conduite d'amenée de gaz, laquelle conduite d'amenée de fluide (9, 10, 11) est reliée à l'entrée de gaz (6, 7, 8) de la chambre de dépôt (2) ; et
- au moins une conduite d'évacuation de fluide (15, 16), de manière préférée une conduite d'évacuation de gaz, laquelle conduite d'évacuation de fluide (15, 16) est reliée à la sortie de gaz (13, 14) de la chambre de dépôt.

7. Dispositif selon la revendication 6,
**caractérisé**
**en ce que** la chambre de dépôt (2) comporte un dispositif de chauffage (17), lequel dispositif de chauffage (17) sert au chauffage de la conduite d'amenée de fluide (9, 10, 11) et/ou de la conduite d'évacuation de fluide (15, 16).

8. Dispositif selon l'une des revendications 6 ou 7,
**caractérisé**
**en ce que** la chambre de dépôt (2) est conformée en un corps creux avec une paroi extérieure (4), laquelle paroi extérieure (4) entoure une zone intérieure (5) de la chambre de dépôt (2), dans laquelle zone intérieure (5) est disposée au moins une cloison (121, 122, 123, 124, 125, 126) pour guider un flux de gaz.

9. Dispositif selon la revendication 8,
**caractérisé**
**en ce que** la surface de dépôt (3) est disposée au moins en partie du côté de la paroi extérieure (4) de la chambre de dépôt (2) tourné vers la zone intérieure (6) et/ou au moins en partie sur la cloison (121, 122, 123, 124, 125, 126).

10. Dispositif selon la revendication 8 ou 9,
**caractérisé**
**en ce que** la zone intérieure (5) de la chambre de dépôt (2) comporte une multiplicité de cloisons (121, 122, 123, 124, 125, 126), lesquelles cloisons (121, 122, 123, 124, 125, 126) divisent la zone intérieure (5) de telle sorte qu'un gaz introduit dans la chambre de dépôt (2) soit guidé de manière sinueuse à travers la chambre de dépôt (2), dans lequel de manière préférée les cloisons (121, 122, 123, 124, 125, 126) sont disposées sensiblement perpendiculairement à l'axe longitudinal de la chambre de dépôt (2).

11. Dispositif selon l'une des revendications 6 à 10,
**caractérisé**
**en ce que** l'entrée de gaz (6, 7, 8) et la sortie de gaz (13, 14) sont disposées de deux côtés de la paroi extérieure (4) de la chambre de dépôt (2) sensiblement opposés.

12. Dispositif selon l'une des revendications 6 à 11,
**caractérisé**
**en ce que** la surface de dépôt (3) est au moins en partie structurée.

13. Dispositif selon l'une des revendications 6 à 12,
**caractérisé**
**en ce que** la surface de dépôt (3) comporte des lamelles et/ou des canaux.

14. Dispositif selon l'une des revendications 6 à 13,
**caractérisé**
**en ce que** la surface de dépôt (3) est réalisée en graphite ou carbure de silicium.
